# EUROPEAN PATENT SPECIFICATION

(11) **EP 0 291 044 B1**
(45) Date of publication and mention of the grant of the patent: **25.08.1993**
(21) Application number: 88107606.1
(22) Date of filing: 11.05.1988
(51) Int. Cl.: C23C 14/34, C23C 14/08, C23C 14/56

(54) **Method and apparatus for sputtering thin film of compound having large area**
Verfahren und Vorrichtung eines dünnen Films mit einer grossen Oberfläche durch Zerstäubung aus einer Verbindung
Procédé et appareillage pour la pulvérisation d'un film mince d'un composé à grande surface

(30) Priority: 12.05.1987 JP 115340/87; 09.05.1988 JP 112101/88
(43) Date of publication of application: 17.11.1988
(73) Proprietor: SUMITOMO ELECTRIC INDUSTRIES LIMITED, Osaka-shi, Osaka 541 (JP)
(72) Inventor: Fujimori, Naoji c/o Itami Works of Sumitomo, Itami-shi Hyogo-ken (JP); Harada, Keizo c/o Itami Works of Sumitomo, Itami-shi Hyogo-ken (JP); Yazu, Shuji c/o Itami Works of Sumitomo, Itami-shi Hyogo-ken (JP); Jodai, Tetsuji c/o Itami Works of Sumitomo, Itami-shi Hyogo-ken (JP)
(74) Representative: Hansen, Bernd, Dr. Dipl.-Chem.

(56) References cited:
- GB-A- 2 101 638
- US-A- 4 046 666
- PERIODIC TABLE, publ. E.H. Sargent & Co.

## Description

### BACKGROUND OF THE INVENTION

### Field of the Invention

The present invention relates to a method and an apparatus for producing a thin film of a compound having a large area. More particularly, it relates to a method for producing a thin film of a compound on an elongate substrate or a large substrate by sputtering the compound on a continuously supplied substrate to form a thin film of the compound on the substrate, and an apparatus for carrying out said method.

### Description of the Related Art

A superconductive phenomenon which is said to be a phase transition of electrons is a phenomenon in which a conductor has zero electric resistance and exhibits complete diamagnetism under specific conditions.

In electronic engineering which is one of technical fields in which the superconductive phenomenon can be utilized, various superconductive devices have been and are proposed and developed. One of the typical devices is an element utilizing the Josephson effect in which the quantum effect is macroscopically exhibited by applied current. Since the superconductor has a small energy gap, a tunnel junction type Josephson element comprising the superconductor is expected as a high speed switching element with small power consumption. Further, since the Josephson effect appears as an exact quantum phenomenon against electromagnetic wave or magnetic field, a Josephson element will be used as a very high sensitive sensor for sensing magnetic field, microwave, radiation, etc.

Since, in a very high speed computer, power consumption per unit area almost reaches the limit of cooling capacity, it is highly desired to provide superconductive elements. In addition as a degree of integration in an electric circuit is increased, it is expected to use a superconductor as a wiring material with little or no current loss.

In spite of enormous efforts, critical temperature Tc of the superconductor could not have exceeded 23K of Nb₃Ge for a long time.

In these years, a sintered material of an oxide such as (La,Ba)₂CuO₄ or (La,Sr)₂CuO₄ was found to be a superconductor with high Tc and is expected to realize high temperature superconductivity. In such oxide superconductors, Tc of 30 to 50 K and sometimes Tc of 70K or higher is observed.

In addition, a composite oxide of the formula: Y₁Ba₂Cu₃O_{7-w} which is referred to as "YBCO" is reported to be a 90K grade superconductor. Further, a Bi-Sr-Ca-Cu type and Tl-Ba-Ca-Cu type composite oxides not only have Tc higher than 100K, but also is chemically stable so that its superconductive properties are less deteriorated as time passes while the superconductive properties of YBCO may be deteriorated as time passes.

Since the oxide superconductor is prepared as a sintered material, it is usually brittle and requires great care in handling. That is, the ceramic oxide superconductor is easily broken or cracked by mechanical stress. Particularly, the ceramic oxide superconductor in the form of a wire is very easily broken. Therefore, its practical use has severe limitation.

Furthermore, it is very difficult to form a sintered superconductor from homogeneous polycrystal consisting of particles all having superconductive characteristics and, as a general property of the superconductor, the superconductive state may be locally broken by fluctuation of external magnetic field or cooling temperature. The ceramic oxide superconductor has smaller thermal conductivity and larger electrical resistance than the classical superconductors. Therefore, when the superconductive state is locally broken, such part of the superconductor is locally heated by electrical current which flows through the superconductor. If the cooling medium contacts the locally heated part of superconductor, it is explosively vaporized.

To prevent such explosive vaporization, the classical metal superconductor is processed in the form of a thin filament and a plural number of filaments are bundled by a good conductive material such as copper, which acts as a thermal conductor and a by-pass of electric current in case of breakage of superconductive state. However, it is difficult to process the ceramic oxide superconductor produced by sintering and having high Tc in the form of filament.

GB-A-2 101 638 discloses a sputtering method using a rotating flexible target which is moved relative to the plasma to extend the life of the target and improve the cooling thereof.

US-A-4 046 666 discloses a method of sputtering with a hot cathode supported discharge having an additional auxiliary electrode which extracts ions from the plasma such that the auxiliary electrode is sputtered from, with the result that material is deposited on the hot cathode to thereby replenish the cathode additive.

To produce the wire or filament form oxide superconductor, it seems to be essential to continuously form a thin film of the superconductor.

As a result of the extensive study, the present inventors have found that a sputtering method in which the superconductive material is used as a target is most suitable for forming a practically applicable thin film of the oxide superconductor.

However, since the oxide superconductor comprises several elements having different vapor pressures, adsorption probabilities and reaction rates, a composition of the compound formed on the substrate differs from that of the target, or the elementary composition on the surface of the target varies during sputtering.

When the thin film is formed on an elongate substrate or a large substrate, it takes a long time to form the thin film on the whole surface of the substrate. Therefore, the composition of the target varies during sputtering, when the compound itself is used as the target.

### SUMMARY OF THE INVENTION

One object of the present invention is to provide a method for continuously producing a thin film of a compound, particularly a ceramic oxide superconductor, having a large area on a substrate.

Another object of the present invention is to provide a method for producing a thin film of a compound having a homogeneous composition on a substrate.

A further object of the present invention is to provide an apparatus for continuously producing a thin film of a compound, particularly a ceramic oxide superconductor, having a large area on a substrate.

According to the first aspect of the present invention, there is provided a method of sputtering a large area thin film of a compound on a substrate from a target member comprising the elements of said compound, said target member having a flat target surface, comprising the steps of:
rotating said target member around an axis which crosses said target surface so that a part of said target surface is positioned at a first sputtering position and another part of said target surface is positioned at a second sputtering position, whereby said target surface is continuously circulated between said first and second sputtering positions, and
at the first position, sputtering from at least one further target comprising at least one element of the compound which is easily sputtered so as to deposit the said easily sputtered element on to said target surface, and
at the second position, sputtering the elements of the compound from the target member so as to deposit them on the surface of said substrate whilst continuously supplying the substrate so that a part of the substrate is positioned in the trajectory of the sputtered elements,
whereby the elementary composition of the target member at the second position is adjusted to have a predetermined composition.

According to the second aspect of the present invention, there is provided a sputtering apparatus for depositing a large area thin film of a compound on a substrate comprising:
a vacuum chamber,
means for supplying an atmospheric gas into the vacuum chamber,
a first target member positioned within the vacuum chamber, said first target member having a flat target surface and comprising the elements of said compound,
a substrate positioned within the vacuum chamber, which substrate is continuously supplied,
a part of said target surface being positionable at a first sputtering position where at least one element constituting the compound is deposited thereon by sputtering from at least one further target comprising said element, and another part of said target surface being positioned at a second sputtering position where the elements constituting the compound are sputtered from the target member onto the surface of said substrate,
wherein the target member is rotatable around an axis which crosses said target surface such that it may be circulated between said first and second positions.

### BRIEF DESCRIPTION OF THE DRAWINGS

Fig. 1 schematically shows an apparatus to be used for forming a thin layer of an oxide superconductor on a substrate according to the present invention,
Fig. 2 schematically shows a right side subroom of the chamber in which magnetron sputtering is used for supplying a deficient element, and
Fig. 3 schematically shows a right side subroom of the chamber in which a metal rod is heated in vacuum by a heater which surround the rod to supply a deficient element.

### DETAILED DESCRIPTION OF THE PREFERRED EMBODIMENTS

The method and apparatus of the present invention are suitable for producing a thin film of an oxide superconductor, particularly, an oxide superconductor having a composition of the formula:

${\text{(M¹}}_{\text{1-x}} {\text{M²}}_{\text{x}} {\text{)M³}}_{\text{y}} {\text{M⁴}}_{\text{z}} \text{(I)}$

wherein M¹ is at least one element selected from the IIa group elements, M² is at least one element selected from the IIIa group elements, M³ is at least one element selected from Ib, IIb, IIIb, IVa and VIIIa group elements, M⁴ is at least one element selected from the group consisting of oxygen, boron, carbon, nitrogen, fluorine and sulfur, x is an atomic ratio of M² to (M¹+M²) and from 0.1 to 0.9 and y and z are atomic ratios of M³ and M⁴ to (M¹+M²) and from 1.0 to 4.0 and from 1 to 5, respectively.

Preferred examples of the IIa group element M¹ are Ba, Sr, Ca, Mg and Be, particularly Ba and Sr. It is preferred that 10 to 80 % of the element M¹ comprises at least one of Mg, Ca and Sr. Preferred examples of the IIIa element M² are Y and lanthanides (e.g. La, Sm, Ce, Gd, Ho, Er, Tm, Yb and Lu), particularly Y, La and Ho. It is preferred that 10 to 80 % of the element M² comprises at least on of Sc and lanthanoids. Generally, the element M³ is Cu, although a part of the element M³ may be replaced with at least one element selected from the Ib, IIb, IIIb, IVa and VIIIa group elements, preferably Ti and V.

Preferred examples of the oxide superconductor (I) are Y₁Ba₂Cu₃O_{7-w}, La₁Ba₂Cu₃O_{7-w}, La₁Sr₂Cu₃O_{7-w}, Ho₁Ba₂Cu₃O_{7-w}, Nd₁Ba₂Cu₃O_{7-w}, Sm₁Ba₂Cu₃O_{7-w}, Eu₁Ba₂Cu₃O_{7-w}, Gd₁Ba₂Cu₃O_{7-w}, Dy₁Ba₂Cu₃O_{7-w}, Er₁Ba₂Cu₃O_{7-w} and Yb₁Ba₂Cu₃O_{7-w} wherein w is larger than 0 (zero) and smaller than 1 (one).

The method and apparatus of the present invention are also suitable for producing a thin film of a superconductor comprising a mixed phase or a single phase of a composite oxide having a composition of the formula:

${\text{M⁵}}_{\text{p}} {\text{(M⁶}}_{\text{1-q}} {\text{,Ca}}_{\text{q}} {\text{)}}_{\text{m}} {\text{Cu}}_{\text{n}} {\text{O}}_{\text{r+s}} \text{(II)}$

wherein M⁵ is Bi or Tl, M⁶ is Sr when M⁵ is Bi or Ba when M⁵ is Tl, p is 4, m is from 6 to 10, n is from 4 to 8, r is (3p+2m+2n)/2, q is larger than 0 (zero) and smaller than 1 (one), and s is from -2 to 2.

Specific examples of the superconductor (II) are Bi₄Sr₄Ca₄Cu₆O₂₀₊ₛ, Bi₂Sr₂Ca₂Cu₃O₁₀₊ₛ, Tl₄Ba₄Ca₄Cu₆O₂₀₊ₛ and Tl₂Ba₂Ca₂Cu₃O₁₀₊ₛ.

As the substrate on which the thin film of the compound is formed, any metallic substrate can be used. Examples of the metallic substrate are those made of stainless steel, Cu, Ag, Au, Pt, Pd, Rh, Fe, Pb, Sn, Cd, Ti, W, Mo, Zr, Hf, Ta, Nb and alloys thereof. Among them, Cu and Fe are preferred since they are inexpensive and easily processed. Pt is also preferred since it is stable and chemically inactive against the oxide superconductor. Further, Ag, Pd and Rh are advantageous as a substrate material particularly for the oxide superconductor which requires control of an oxygen content, since some kinds of their oxides liberate oxygen by temperature change. Preferably, the surface of substrate made of these materials, is coated with ZrO₂ or MgO. This is because the critical current density of the oxide superconductor has crystal anisotropy. When the oxide superconductor is formed on the layer of Zr₂O or MgO, its crystal has orientation in a direction of the c axis so that the critical current density can be increased and a current direction in which the critical current density is large can be controlled.

To supply the deficient element to the target member at the first position, sputtering is used. Particularly, ion beam sputtering is preferred.

The second sputtering of the compound onto the substrate can be carried out by any of conventional sputtering methods. Among them, magnetron sputtering is preferred.

It is preferred to heat the substrate at a temperature of 500 to 1,000°C. It is also preferred to post heat the formed thin layer of the oxide superconductor in an oxygen-containing atmosphere at a temperature of 500 to 1,000°C and to anneal the oxide superconductor by cooling it at a cooling rate of 10°C/min. or less. By annealing, oxygen defects in the oxide superconductor crystal are removed so that the superconductive properties are improved.

In the apparatus of the present invention, the easily splashable element is supplied to a part of the target member at the first sputtering position and then said part of the target member is circulated to the second sputtering position at which all the elements are sputtered to deposit them on the surface of the substrate. Then, said part is returned to the first position and the element is supplied thereto. Therefore, each part of the target member which is moved to the second position contains all the elements in a desired ratio, and the thin film of the compound with a homogeneous composition can be formed continuously on the elongate or large substrate.

The target member is preferably in the form of a cylinder or a disc and circulated between the first and second sputtering positions by rotation. When the first and second sputtering positions require different sputtering conditions such as atmosphere, the chamber of the apparatus is partitioned by a wall into two subrooms, and the target member is circulated between two subrooms with keeping the atmosphere of each subroom by differential exhaust.

In the present invention, the substrate is preferably of linear form such as a tape or a sheet and continuously supplied in the chamber of the sputtering apparatus.

According to the present invention, the composition of the target member can be kept constant for a long time, and it is possible to form the homogeneous thin layer of the compound on a whole length of a continuously supplied elongate substrate.

One of particularly advantageous application of the present invention is production of a linear form oxide superconductor.

### PREFERRED EMBODIMENTS OF THE INVENTION

Preferred embodiments of the present invention will be illustrated by way of example by making reference to the accompanying drawings.

### Example 1

By the method of the present invention, a thin film of an oxide superconductor having a composition of Ba₂YCu₃O₇ was formed on an elongate tape made of stainless steel.

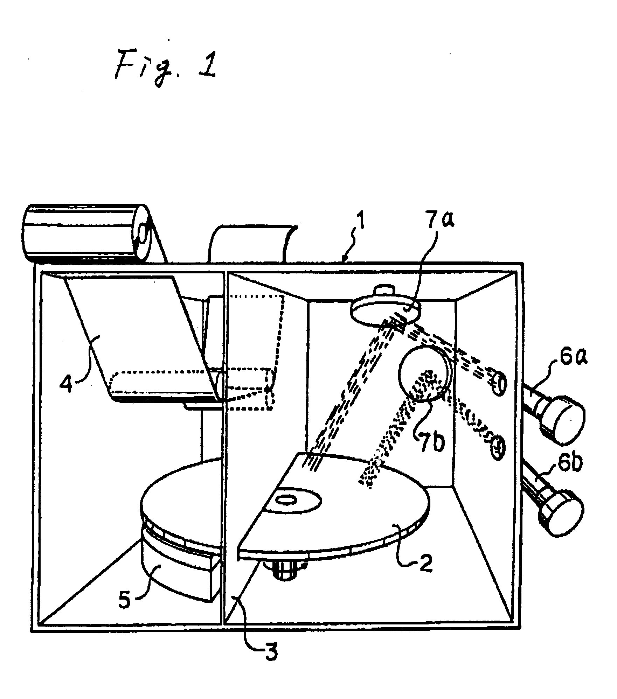

An apparatus used in this Example is schematically shown in Fig. 1.

The apparatus of Fig. 1 comprises a sputtering chamber 1, at a substantially center position of which, a disc shaped target member 2 is installed. The target member consists of a sintered oxide material a composition of which is adjusted by taking the formation of the thin film by RF sputtering into consideration.

A wall 3 divides the chamber 1 into two subrooms. In a left side subroom, spattering of the compound is carried out to form a thin film of the compound on a stainless steel tape 4. To this purpose, a magnet 5 is placed beneath the target member 2 to establish magnetron conditions. On a right side of the wall, a pair of ion beam sputtering apparatuses 6a and 6b and a pair of targets 7a and 7b are positioned to supply the deficient elements to the target member 2.

The target member 2 rotated at a predetermined rate. In the left side subroom, it is used as a source member for sputtering the compound onto the substrate, and then it is supplied with the deficient element(s) in the right side subroom.

In case of sputtering of a Ba-Y-Cu composite material, Y tends to remain in the target member, while Ba is most easily splashed. Therefore, in this Example, Cu and Ba were supplied from the targets 7a and 7b, respectively.

When the RF sputtering is effected in the right side subroom, high frequency fills the whole chamber 1. Therefore, some measure should be taken to prevent the sputtering induced by such high frequency in the left side subroom. To this end, ion beam sputtering under highly reduced pressure is preferred to supply the deficient elements in the right side subroom. The supplied amounts of the elements can be controlled by adjusting accelerating voltages of ion sources and gas pressure in the chamber 1. Preferably, pressure in the right and left side subrooms is adjusted independently from each other by installing an independent exhausting means to each subroom. In the apparatus used in this Example, a rotary pump and an oil diffusion pump are connected to each subroom, and pressure is reduced to around 0.132 Pa (10⁻³ Torr) by the rotary pump and then precisely controlled by the oil diffusion pump.

The parameters and conditions used in this Example were as follows:
(1) Target member (disc form)
   Sintered material of BaY₂CuO₇
   Outer diameter: 38.1 cm (15 inches)
   Inner diameter: 17.8 cm (7 inches)
   Applied output power: 10 W/cm²
   Rotation speed: 0.5 rpm
   Deposition rate: 1 nm/sec.
(2) Sputtering conditions on the substrate
   Magnetic field: 300 G on the substrate surface
   Substrate temperature: 700°C
   Partial pressure of argon: 1.06 Pa (8 x 10⁻³ Torr)
   Partial pressure of oxygen: 0.264 Pa (2 x 10⁻³ Torr)
(3) Sputtering conditions for supplying deficient element
   Target 7a: Cu
   Target 7b: Ba
   Vacuum: 0.066 Pa (5 x 10⁻⁴ Torr) (argon)
   Accelerating voltage:
   Ion source 6a: 4 kV
   Ion source 6b: 5 kV

The target disc member 2 may be produced as follows:

A mixture of powdery oxides, carbonates, nitrates or sulfates of Ba, Y and Cu in a predetermined weight ratio is molded in a suitable shape and then sintered at a high temperature according to a conventional method. Preferably, after the molded mixture is presintered, it is ground, molded and again sintered.

Although in the above Example the ion beam spattering was used for supplying the deficient elements, any other suitable methods can be used for supplying the deficient elements. Further, not only Ba and Cu but also Y can be supplied so as to more precisely control the growing rate of the thin film of the compound and/or the elementary composition of the compound.

Fig. 2 schematically shows another embodiment of a right side subroom of the chamber 1 in which magnetron sputtering is used for supplying a deficient element to the target member 2. A magnetron electrode 9 is installed over the target member 1 and connected to a high frequency source 8. In the electrode 9, the target 7 for the deficient element is positioned.

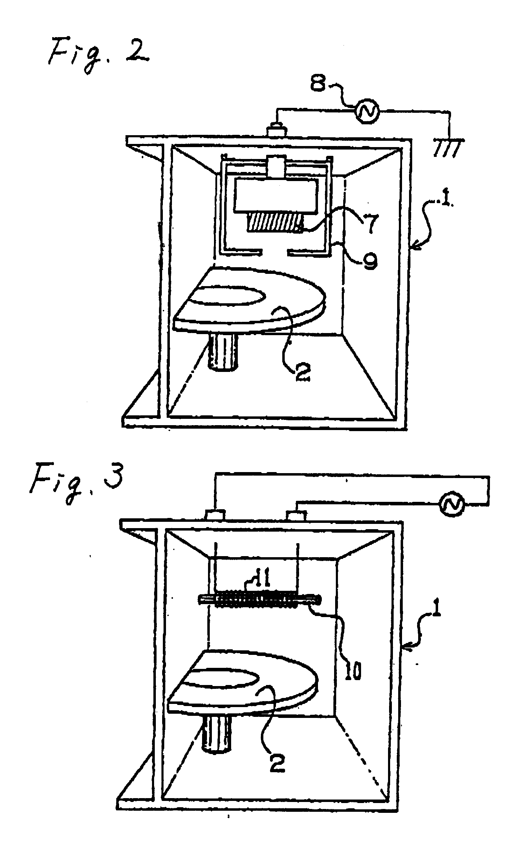

Fig. 3 schematically shows an embodiment of a right side subroom of the chamber 1, which is not claimed, in which a metal rod 10 (for example, a copper rod) is heated in vacuum by a heater 11 which surround the rod 10 to evaporate the metal and deposit it on the target member 2 for supplying the deficient element (for example, copper).

### Example 2

By using the apparatus of Fig 1, a thin layer of an oxide superconductor having a composition of Bi₄Sr₄Ca₄Cu₆O₂₀₊ₛ was formed on an elongate tape made of stainless steel having a layer of ZrO₂ on the surface.

In case of sputtering of a Bi-Sr-Ca-Cu composite material under the same conditions, Sr and Ca tend to remain in the target member, while Bi is most easily splashed. Therefore, in this Example, Bi and Cu were supplied from the targets 7a and 7b, respectively.

The parameters and conditions used in this Example were as follows:
(1) Target member (disc form)
   Sintered material of Bi₄Sr₄Ca₄Cu₆O₂₀₊ₛ
   Outer diameter: 38.1 cm (15 inches)
   Inner diameter: 17.8 cm (7 inches)
   Applied output power: 10 W/cm²
   Rotation speed: 0.5 rpm
   Deposition rate: 1 nm/sec.
(2) Sputtering conditions on the substrate
   Magnetic field: 300 G on the substrate surface
   Substrate temperature: 700°C
   Partial pressure of argon: 1.06 Pa (8 x 10⁻³ Torr)
   Partial pressure of oxygen: 0.264 Pa (2 x 10⁻³ Torr)
(3) Sputtering conditions for supplying deficient element
   Target 7a: Bi
   Target 7b: Cu
   Vacuum: 0.066 Pa (5 x 10⁻⁴ Torr) (argon)
   Accelerating voltage:
   Ion source 6a: 4 kV
   Ion source 6b: 5 kV

The disc shape target member 2 was prepared by sintering a mixture of Bi₂O₃ powder, SrCO₃ powder, CaCO₃ powder and Cu powder in such ratio that an atomic ratio of Bi:Sr:Ca:Cu was 2:2:2:3 by a conventional method.

The present invention is not limited to the above illustrated embodiments.

When the thin film of the oxide superconductor is formed on a large area substrate, a shielding member can be produced. When a masking element is positioned over the substrate or a drum and the thin film of the oxide superconductor is formed through the mask, a coil for superconductive magnet can be produced.

## Claims

1. A method of sputtering a large area thin film of a compound on a substrate (4) from a target member (2) comprising the elements of said compound, said target member (2) having a flat target surface, comprising the steps of:
rotating said target member (2) around an axis which crosses said target surface so that a part of said target surface is positioned at a first sputtering position and another part of said target surface is positioned at a second sputtering position, whereby said target surface is continuously circulated between said first and second sputtering positions, and
at the first position, sputtering from at least one further target (7,7a,7b) comprising at least one element of the compound which is easily sputtered so as to deposit the said easily sputtered element on to said target surface, and
at the second position, sputtering the elements of the compound from the target member (2) so as to deposit them on the surface of said substrate (4) whilst continuously supplying the substrate (4) so that a part of the substrate (4) is positioned in the trajectory of the sputtered elements,
whereby the elementary composition of the target member (2) at the second position is adjusted to have a predetermined composition.

2. The method according to claim 1, wherein the target member (2) is in the form of a cylinder or disc and rotated around the axis of the cylinder or the center of the disc.

3. The method according to claim 1, wherein the compound to be sputtered is a high temperature oxide superconductor having a composition of the formula:
${\text{(M¹}}_{\text{1-x}} {\text{M²}}_{\text{x}} {\text{)M³}}_{\text{y}} {\text{M⁴}}_{\text{z}} \text{(I)}$
wherein M¹ is at least one element selected from the group of Ba, Sr and Ca, M² is at least one element selected from the group of Y and the lanthanide elements, M³ is Cu and optionally Ti and/or V, M⁴ is oxygen, x is the atomic ratio of M² to (M¹+M²) and is from 0.1 to 0.9 and y and z are the atomic ratios of M³ and M⁴ to (M¹+M²) and are from 1.0 to 4.0 and from 1 to 5, respectively.

4. The method according to claim 1, wherein the substrate (4) on which the thin film of the compound is formed is a metallic substrate (4) made of a metal selected from the group consisting of stainless steel, Cu, Ag, Au, Pt, Pd, Rh, Fe, Pb, Sn, Cd, Ti, W, Mo, Zr, Hf, Ta, Nb and alloys thereof.

5. The method according to claim 1, wherein the substrate (4) comprises a non-metallic base material coated with a layer of a metal selected from the group consisting of stainless steel, Cu, Ag, Au, Pt, Pd, Rh, Fe, Pb, Sn, Cd, Ti, W, Mo, Zr, Hf, Ta, Nb and alloys thereof.

6. The method according to claim 1, wherein the sputtering at the first position consists of ion beam sputtering.

7. The method according to claim 1, wherein the sputtering at the second position consists of magnetron sputtering.

8. The method according to claim 1, wherein the substrate is heated at a temperature of from 230 to 1,410°C during sputtering.

9. The method according to claim 1, wherein the substrate (4) is heated at a temperature of from 230 to 1,410°C after forming the thin film of the compound thereon.

10. A sputtering apparatus for depositing a large area thin film of a compound on a substrate comprising:
a vacuum chamber (1),
means for supplying an atmospheric gas into the vacuum chamber (1),
a first target member (2) positioned within the vacuum chamber (1), said first target member (2) having a flat target surface and comprising the elements of said compound,
a substrate (4) positioned within the vacuum chamber (1), which substrate (4) is continuously supplied,
a part of said target surface being positionable at a first sputtering position where at least one element constituting the compound is deposited thereon by sputtering from at least one further target (7,7a,7b) comprising said element, and another part of said target surface being positioned at a second sputtering position where the elements constituting the compound are sputtered from the target member (2) onto the surface of said substrate (4),
wherein the target member (2) is rotatable around an axis which crosses said target surface such that it may be circulated between said first and second positions.

11. The apparatus according to claim 10, wherein the target member (2) is in the form of a cylinder or disc and is rotatable around the axis of the cylinder or the center of the disc.

12. The apparatus according to claim 10, wherein said at least one further target is a target of an ion beam sputtering apparatus.

13. The apparatus according to claim 10, wherein said first target member (2) is a target of a magnetron sputtering apparatus.

## Patentansprüche

1. Verfahren zur Aufstäubung eines dünnen Filmes einer Verbindung, der eine große Oberfläche besitzt auf einem Substrat (4) von einem Auftreffelement (2), das die Elemente dieser Verbindung umfaßt, wobei das Auftreffelement (2) eine flache Auftrefffoberfläche besitzt, umfassend die Stufen:
Rotierenlassen des Auftreffelements (2) um eine Achse, die die Auftreffoberfläche so schneidet, daß ein Teil der Auftreffoberfläche in einer ersten Sputtering-Position und ein anderer Teil der Auftreffoberfläche in einer zweiten Sputtering-Position positioniert wird, und wodurch die Auftreffoberfläche kontinuierlich zwischen diesen ersten und zweiten Sputtering-Positionen zirkuliert wird, und
Sputtering von mindestens einer weiteren Auftreffplatte (7, 7a, 7b), die mindestens ein Element der Verbindung umfaßt, das leicht gesputtert wird, in der ersten Position, um das leicht gesputterte Element auf der Auftreffoberfläche abzuscheiden, und
Sputtering der Elemente der Verbindung aus dem Auftreffelement (2) in der zweiten Position, um sie an der Oberfläche des Substrats (4) abzuscheiden, während das Substrat (4) kontinuierlich zugeführt wird, damit sich ein Teil des Substrats (4) in der Bahn der gesputterten Elemente befindet,
wodurch die elementare Zusammensetzung des Auftreffelements (2) in der zweiten Position eingestellt wird, damit sie eine vorher festgesetzte Zusammensetzung aufweist.

2. Verfahren nach Anspruch 1, dadurch gekennzeichnet, daß das Auftreffelement (2) die Form eines Zylinders oder einer Scheibe besitzt, und um die Achse des Zylinders oder den Mittelpunkt der Scheibe rotiert wird.

3. Verfahren nach Anspruch 1, dadurch gekennzeichnet, daß die aufzustäubende Verbindung ein oxidischer Hochtemperatur-Supraleiter mit der Zusammensetzung der Formel ist:
${\text{(M¹}}_{\text{1-x}} {\text{M²}}_{\text{x}} {\text{)M³}}_{\text{y}} {\text{M⁴}}_{\text{z}} \text{(I)}$
worin M¹ mindestens ein Element ausgewählt aus der Gruppe Ba, Sr und Ca ist, M² mindestens ein Element ausgewählt aus der Gruppe Y und den Lanthaniden ist, M³ Kupfer und gegebenenfalls Ti und/oder V ist, M⁴ Sauerstoff ist, x das Atomverhältnis von M² zu (M¹+M²) bedeutet und 0,1 bis 0,9 beträgt und y bzw. z die Atomverhältnisse von M³ bzw. M⁴ zu (M¹+M²) sind und 1,0 bis 4,0 bzw. 1 bis 5 betragen.

4. Verfahren nach Anspruch 1, dadurch gekennzeichnet, daß das Substrat (4), auf dem der dünne Film der Verbindung ausgebildet wird, ein metallisches Substrat (4) aus einem Metall ist, das ausgewählt ist aus der Gruppe bestehend aus rostfreiem Stahl, Cu, Ag, Au, Pt, Pd, Rh, Fe, Pb, Sn, Cd, Ti, W, Mo, Zr, Hf, Ta, Nb und Legierungen davon.

5. Verfahren nach Anspruch 1, dadurch gekennzeichnet, daß das Substrat (4) ein nichtmetallisches Basismaterial umfaßt, das mit einer Schicht eines Metalles beschichtet ist, das ausgewählt ist aus der Gruppe bestehend aus rostfreiem Stahl, Cu, Ag, Au, Pt, Pd, Rh, Fe, Pb, Sn, Cd, Ti, W, Mo, Zr, Hf, Ta, Nb und Legierungen davon.

6. Verfahren nach Anspruch 1, dadurch gekennzeichnet, daß das Sputtering in der ersten Position ein Ionenstrahl-Sputtering ist.

7. Verfahren nach Anspruch 1, dadurch gekennzeichnet, daß das Sputtering in der zweiten Position ein Magnetron-Sputtering ist.

8. Verfahren nach Anspruch 1, dadurch gekennzeichnet, daß das Substrat während des Sputtering bei einer Temperatur von 230 bis 1410°C erhitzt wird.

9. Verfahren nach Anspruch 1, dadurch gekennzeichnet, daß das Substrat (4) nach Ausbildung des dünnen Filmes der Verbindung auf ihm bei einer Temperatur von 230 bis 1410°C erhitzt wird.

10. Sputtering-Vorrichtung zur Abscheidung eines dünnen Filmes einer Verbindung, der eine große Oberfläche besitzt, an einem Substrat umfassend:
eine Vakuumkammer (1),
Mittel zur Zufuhr eines atmosphärischen Gases in die Vakuumkammer (1),
ein erstes Auftreffelement (2), das sich in der Vakuumkammer (1) befindet, wobei dieses erste Auftreffelement (2) eine flache Auftreffoberfläche besitzt und die Elemente dieser Verbindung umfaßt,
ein Substrat (4) innerhalb der Vakuumkammer (1), das kontinuierlich zugeführt wird,
wobei ein Teil der Auftreffoberfläche in einer ersten Sputtering-Position positionierbar ist, wo mindestens ein Element der Verbindung durch Sputtering von mindestens einem weiteren Auftreffelement (7, 7a, 7b), das dieses Element umfaßt, darauf abgeschieden wird, und ein anderer Teil der Auftreffoberfläche in einer zweiten Sputtering-Position positioniert ist, wo die Elemente, die die Verbindung aufbauen, von dem Auftreffelement (2) auf die Oberfläche des Substrats (4) gesputtert werden,
und worin das Auftreffelement (2) um eine Achse drehbar ist, die die
Auftreffoberfläche so schneidet, daß sie zwischen den ersten und zweiten Positionen zirkuliert werden kann.

11. Vorrichtung nach Anspruch 10, dadurch gekennzeichnet, daß das Auftreffelement (2) die Form eines Zylinders oder einer Scheibe besitzt und um die Achse des Zylinders oder den Mittelpunkt der Scheibe drehbar ist.

12. Vorrichtung nach Anspruch 10, dadurch gekennzeichnet, daß das mindestens eine weitere Auftreffelement ein Auftreffelement einer Ionenstrahl-Sputtering-Einrichtung ist.

13. Vorrichtung nach Anspruch 10, dadurch gekennzeichnet, daß das erste Auftreffelement (2) ein Auftreffelement einer Magnetron-Sputtering-Einrichtung ist.

## Revendications

1. Procédé de pulvérisation d'un film mince grande surface d'un composé sur un substrat (4) depuis un élément de cible (2) comprenant les éléments dudit composé, ledit élément de cible (2) comportant une surface de cible, comprenant les étapes de :
mise en rotation dudit élément de cible (2) autour d'un axe qui coupe ladite surface de cible de telle sorte qu'une partie de ladite surface de cible soit positionnée en une première position de pulvérisation et qu'une autre partie de ladite surface de cible soit positionnée en une seconde position de pulvérisation d'où il résulte que ladite surface de cible est déplacée en continu entre lesdites première et seconde positions de pulvérisation ; et
au niveau de la première position, pulvérisation depuis au moins une autre cible (7, 7a, 7b) comprenant au moins un élément du composé qui est facilement pulvérisé de manière à déposer ledit élément facilement pulvérisé sur ladite surface de cible ; et
au niveau de la seconde position, pulvérisation des éléments du composé depuis l'élément de cible (2) de manière à les déposer sur la surface dudit substrat (4) tout en appliquant en continu le substrat (4) de telle sorte qu'une partie du substrat (4) soit positionnée sur la trajectoire des éléments pulvérisés,
d'où il résulte que la composition élémentaire de l'élément de cible (2) au niveau de la seconde position est réglée de manière à présenter une composition prédéterminée.

2. Procédé selon la revendication 1, dans lequel l'élément de cible (2) se présente sous la forme d'un cylindre ou disque et est tourné autour de l'axe du cylindre ou du centre du disque.

3. Procédé selon la revendication 1, dans lequel le composé qui doit être pulvérisé est un oxyde supraconducteur haute température présentant une composition donnée par la formule :
${\text{(M¹}}_{\text{1-x}} {\text{M²}}_{\text{x}} {\text{)M³}}_{\text{y}} {\text{M⁴}}_{\text{z}} \text{(1)}$
où M¹ est au moins un élément sélectionné parmi le groupe qui comprend le Ba, le Sr et le Ca, M² est au moins un élément sélectionné parmi le groupe qui comprend le Y et les éléments lanthanide, M³ est du Cu et optionnellement du Ti et/ou du V, M⁴ est de l'oxygène, x est le rapport atomique du M² sur (M¹ + M²) et varie en 0,1 et 0,9 et y ainsi que z sont respectivement des rapports atomiques du M³ et du M⁴ sur (M¹ + M²) et varient respectivement entre 1,0 et 4,0 et entre 1 et 5.

4. Procédé selon la revendication 1, dans lequel le substrat (4) sur lequel le film mince du composé est formé est un substrat métallique (4) réalisé en un métal sélectionné parmi le groupe qui comprend l'acier inoxydable, le Cu, l'Ag, l'Au, le Pt, le Rh, le Fe, le Pb, le Sn, le Cd, le Ti, le W, le Mo, le Zr, le Hf, le Ta, le Nb et des alliages de ceux-ci.

5. Procédé selon la revendication 1, dans lequel le substrat (4) comprend un matériau de base non métallique recouvert d'une couche d'un métal sélectionné parmi le groupe qui comprend l'acier inoxydable, le Cu, l'Ag, l'Au, le Pt, le Rh, le Fe, le Pb, le Sn, le Cd, le Ti, le W, le Mo, le Zr, le Hf, le Ta, le Nb et des alliages de ceux-ci.

6. Procédé selon la revendication 1, dans lequel la pulvérisation au niveau de la première position consiste en une pulvérisation par faisceau ionique.

7. Procédé selon la revendication 1, dans lequel la pulvérisation au niveau de la seconde position consiste en une pulvérisation par magnétron.

8. Procédé selon la revendication 1, dans lequel le substrat est chauffé à une température qui va de 230° C à 1410° C pendant la pulvérisation.

9. Procédé selon la revendication 1, dans lequel le substrat (4) est chauffé à une température qui va de 230° C à 1410° C après formation du film mince du composé dessus.

10. Appareil de pulvérisation pour déposer un film mince grande surface d'un composé sur un substrat, comprenant :
une chambre sous vide (1) ;
un moyen pour appliquer un gaz atmosphérique à l'intérieur de la chambre sous vide (1) ;
un premier élément de cible (2) positionné dans la chambre sous vide (1), ledit premier élément de cible (2) comportant une surface de cible et comprenant les éléments dudit composé ;
un substrat (4) positionné à l'intérieur de la chambre sous vide (1), lequel substrat (4) est appliqué en continu ;
une partie de ladite surface de cible pouvant être positionnée au niveau de ladite première position de pulvérisation où au moins un élément qui constitue le composé est déposé dessus au moyen d'une pulvérisation depuis au moins une autre cible (7, 7a, 7b) comprenant ledit élément et une autre partie de ladite surface de cible étant positionnée en une seconde position de pulvérisation où les éléments constituant le composé sont pulvérisés depuis l'élément de cible (2) sur la surface dudit substrat (4),
dans lequel l'élément de cible (2) peut tourner autour d'un axe qui coupe ladite surface de cible de telle sorte qu'il puisse être déplacé entre lesdites première et seconde positions.

11. Appareil selon la revendication 10, dans lequel l'élément de cible (2) se présente sous la forme d'un cylindre ou disque et peut tourner autour d'un axe du cylindre ou du centre du disque.

12. Appareil selon la revendication 10, dans lequel ladite au moins une autre cible est une cible d'un appareil de pulvérisation par faisceau ionique.

13. Appareil selon la revendication 10, dans lequel ledit premier élément de cible (2) est une cible d'un appareil de pulvérisation par magnétron.
